# EUROPÄISCHE PATENTSCHRIFT

(11) **EP 2 258 004 B1**
(45) Veröffentlichungstag und Bekanntmachung des Hinweises auf die Patenterteilung: **18.01.2012**
(21) Anmeldenummer: 09713762.4
(22) Anmeldetag: 05.02.2009
(51) Int. Cl.: H01L 41/09

(54) **HOCHPRÄZISER ULTRASCHALLMOTOR**
HIGH-PRECISION ULTRASONIC MOTOR
MOTEUR À ULTRASONS DE HAUTE PRÉCISION

(30) Priorität: 28.02.2008 DE 102008011741; 21.11.2008 DE 102008058484
(43) Veröffentlichungstag der Anmeldung: 08.12.2010
(73) Patentinhaber: Physik Instrumente (PI) GmbH & Co. KG, 76228 Karlsruhe (DE)
(72) Erfinder: WISCHNEWSKIJ, Alexej, 76744 Wörth (DE); WISCHNEWSKIY, Wladimir, 76337 Waldbronn (DE)
(74) Vertreter: Meissner, Bolte & Partner
(86) Internationale Anmeldenummer: PCT/EP2009/051310
(87) Internationale Veröffentlichungsnummer: WO 2009/106412

(56) Entgegenhaltungen:
- US-A1- 2001 011 860
- US-A1- 2006 283 253

## Beschreibung

Die vorliegende Erfindung betrifft einen hochpräzisen Ultraschallmotor, umfassend ein Gehäuse und zumindest einen in dem Gehäuse angeordneten Oszillator, vorzugsweise in Form einer piezoelektrischen Platte, an dem wenigstens ein Friktionselement angeordnet ist, welches zur Kontaktierung einer Friktionsoberfläche eines damit anzutreibenden Elements vorgesehen ist, sowie einer Anpressvorrichtung zum Anpressen des Friktionselements an die Friktionsoberfläche, wobei das Gehäuse zumindest zwei Stützmittel zum Kontaktieren einer jeweils zugeordneten Stirnfläche des Oszillators aufweist.

Derartige Ultraschallmotoren können beispielsweise in hochpräzisen technologischen Ein-, Zwei- oder Dreikoordinatentischen, in hochpräzisen Mikroskoptischen, in hochpräzisen optischen Systemen wie z. B. in Objektiven hochpräziser Fotoapparate oder in geophysikalischen Geräten verwendet werden.

Aus der Druckschrift US 5,872,418 sind Ultraschallmotoren bekannt, in denen der Ultraschalloszillator mit Hilfe von Gummihaltern gehalten wird (Halter 8 in den Fig. 32, 34 und 35 der obigen Druckschrift). Derartige Motoren zeichnen sich durch eine einfache Montagetechnologie und niedrige Herstellungskosten aus, jedoch lassen sie keine hohen Positionierungsgenauigkeiten zu. Der Gummihalter bestimmt die niedrige Motorsteifigkeit. Überdies hat der Gummihalter eine Hysterese, die den Empfindlichkeitsbereich des Motors bestimmt. Sowohl die Motorsteifigkeit, als auch die Hysterese der Gummihalter begrenzt die Positionierungsgenauigkeit derartiger Ultraschallmotoren. Die Positionierungsgenauigkeit beträgt hierbei etwa 5 - 10 µm. In vielen Fällen reicht diese Genauigkeit nicht aus.

Aus der Druckschrift US 6,979,934 ist ferner ein Ultraschallmotor bekannt, bei dem der Ultraschalloszillator durch einen doppelten Metallrahmen gehalten wird (Fig. 3, 5, 7 der obigen Druckschrift). Die Rahmen werden mit Epoxydharzkleber auf die Zylinderoberfläche des Motors aufgeklebt. Ein solcher Motor besitzt aufgrund einer hohen Motorsteifigkeit und einer geringen Hysterese eine hohe Positionierungsgenauigkeit, die im Bereich von 0,1 µm liegt. Der Motor weist jedoch den Nachteil auf, dass seine Montage eine präzise Verklebung der Doppelrahmen an den Oszillator erfordert. Dieser Arbeitsgang erfolgt manuell, was den Motor verteuert.

Des Weiteren ist aus der Druckschrift US 2003/005 25 73 A1 ein Ultraschallmotor bekannt, bei dem sich der als piezoelektrische Platte ausgeführte Ultraschalloszillator in einem ersten Gehäuseteil befindet, das zwei Anschläge aufweist, welche den Oszillator an seinen zwei Stirnflächen festhalten. Der zweite Gehäuseteil bildet den Deckel für den ersten Teil (Fig. 34 der obigen Druckschrift). Der wesentliche Nachteil dieses Motors besteht darin, dass für die hochpräzise Positionierung der Oszillator fest im ersten Gehäuseteil fixiert sein muss. Die Toleranzen der Oszillatorabmessungen im ersten Gehäuseteil müssen immer garantieren, dass kein Spalt zwischen den Anschlägen und den Stirnflächen des Oszillators vorhanden ist. Bereits das Auftreten eines kleinen Spaltes verschlechtert die Positionierungsgenauigkeit um die entsprechende Spaltgröße. Gleichzeitig darf der Oszillator nicht stark zwischen den Anschlägen eingespannt werden. Das Einklemmen des Oszillators zwischen den Anschlägen führt zum Auftreten von Verlusten zwischen dem Oszillator und den Anschlägen und zur Erhöhung der in das Motorgehäuse gelangenden akustischen Energie, die wiederum zur Motorerwärmung und zu verstärkten Motorgeräuschen führt. Außerdem verringert das Klemmen des Oszillators wesentlich seine effektive Güte. Die damit verbundene Verschlechterung der Stabilität des Motors bei Last- und Temperaturänderungen schließt den Betrieb des Motors in selbsterregenden Generatorschaltungen aus.

Zur Gewährleistung einer Positionierungsgenauigkeit von 0,01 µm muss der Oszillator des Motors eine positive Toleranz von 2 - 5 µm, bezogen auf die Anschläge des Gehäuses, haben. Eine kleinere Toleranz führt zum Auftreten eines Spaltes, was seinerseits zur Verringerung der Positionierungsgenauigkeit führt. Bei einer großen Toleranz wird der Oszillator stark durch die Anschläge zusammengepresst und kann sich dadurch zwischen ihnen verklemmen. Daher ist die Einhaltung entsprechender Toleranzen enorm wichtig. Bei einer Massenfertigung ist es jedoch sehr schwierig, genaue Toleranzen zu gewährleisten. Die Einhaltung genauer Toleranzen führt zudem zu höheren Herstellungskosten für solche Ultraschallmotoren.
In diesem Zusammenhang ist zu erwähnen, dass auch die Gehäusetemperatur Einfluss auf die Klemm- bzw. Haltesituation des Oszillators hat. So kann eine Verringerung der Gehäusetemperatur zum unzulässigen Zusammenpressen des Oszillators führen, während die Erhöhung der Gehäusetemperatur zum Auftreten eines Spaltes führen kann, was wiederum den Verlust an Genauigkeit nach sich zieht. Aus diesem Grund können derartige Ultraschallmotoren nicht in hochpräzisen Geräten eingesetzt werden, die entsprechenden äußeren Umgebungseinflüssen ausgesetzt sind.

Das Ziel der vorliegenden Erfindung besteht deshalb darin, die Technologie zur Herstellung von hochpräzisen Ultraschallmotoren für eine kostengünstige Massenfertigung zu vereinfachen und zugleich die Positionierungsgenauigkeit dieser Motoren zu erhöhen. Darüber hinaus sollen die Verluste, die Erwärmung und die akustischen Geräuschpegel beim Betrieb derartiger Motoren reduziert werden. Ebenso ist es das Ziel der vorliegenden Erfindung, die Funktionsstabilität zu erhöhen und den Temperatureinsatzbereich von Ultraschallmotoren zu erweitern.

Der vorliegenden Erfindung liegt daher die Aufgabe zugrunde, einen hochpräzisen Ultraschallmotor der eingangs genannten Art derart weiterzubilden, dass die aus dem Stand der Technik bekannten und oben diskutierten Probleme und Nachteile reduziert werden und insbesondere einen hochpräzisen Ultraschallmotor mit neuen vorteilhaften Eigenschaften bereitzustellen, der einen einfacheren Aufbau besitzt.

Diese Aufgabe wird erfindungsgemäß gelöst durch einen hochpräzisen Ultraschallmotor der eingangs genannten Art, bei dem die Stützmittel relativ zueinander verschiebbar angeordnet sind, so dass sie während der Montage des Ultraschallmotors unabhängig voneinander von einer von der jeweils zugeordneten Stirnfläche beabstandeten Position in eine Anlageposition, bei welcher sie sich zumindest abschnittsweise in Anlage mit der jeweils zugeordneten Stirnfläche befinden, überführbar sind. Als zugeordnete Stirnfläche ist hierbei jeweils die Stirnfläche des Oszillators zu verstehen, für die eine Kontaktierung mit dem entsprechenden, während der Montage in gegenübertiegende Anordnung gelangenden Stützmittel vorgesehen ist.

Weitere bevorzugte Ausgestaltungen der Erfindung sind Gegenstand der Unteransprüche.

Es kann von Vorteil sein, dass zumindest eines der Stützmittel einstückig mit dem Gehäuse ausgeführt ist. Dies erleichtert die Herstellungstechnologie derartiger Motoren.

Zudem kann es von Vorteil sein, dass zumindest eines der Stützmittel vor der Montage des Ultraschallmotors als vom Gehäuse separates Teil vorliegt und während der Montage des Ultraschallmotors mit dem Gehäuse verbindbar ist. Dies kann ebenso vorteilhaft für die Herstellung des Motors sein und erweitert außerdem die konstruktiven Möglichkeiten.

Des Weiteren kann es von Vorteil sein, dass zumindest eines der Stützmittel einen höheren Temperaturausdehnungskoeffizienten als das Gehäuse aufweist. Dies ermöglicht es, den Temperatureinsatzbereich zu erweitern.

Außerdem kann es von Vorteil sein, dass das Gehäuse einen metallischen Werkstoff, vorzugsweise Aluminium, aufweist, und dass zumindest eines der Stützmittel einen polymeren Werkstoff, vorzugsweise einen thermoplastischen Kunststoff, aufweist. Diese Werkstoffe sind vergleichsweise einfach in Form bringbar bzw. bearbeitbar. Insbesondere die polymeren Werkstoffe lassen sich leicht und kostengünstig verarbeiten. Darüber hinaus weisen polymere Werkstoffe und in erster Linie die thermoplastischen Kunststoffe günstige tribologische Eigenschaften wie beispielsweise einen niedrigen Reibungskoeffizienten im Kontakt mit anderen Werkstoffen, z.B. Keramik, auf. Darüber hinaus kann es von Vorteil sein, dass das Gehäuse wenigstens zwei Gehäuseteile aufweist. Dies erweitert die konstruktiven Möglichkeiten.

Es kann günstig sein, dass die Gehäuseteile im Wesentlichen gleiche Geometrie und/oder gleiche Abmessungen und/oder gleiche Ausführung aufweisen. Dies vereinfacht die Motorkonstruktion.

Zudem kann es günstig sein, dass zumindest eines der Stützmittel wenigstens einen akustisch beweglichen Abschnitt, vorzugsweise in Form einer Membran oder eines flachen Bandes, aufweist. Dadurch wird die Dämpfung des Oszillators verringert.

Ebenso kann es günstig sein, dass der akustisch bewegliche Abschnitt als einseitig freier Schenkel ausgeführt ist. Auch hierdurch wird die Dämpfung des Oszillators verringert.

Zudem kann es günstig sein, dass eine zur Kontaktierung der zugeordneten Stirnfläche des Oszillators vorgesehene Oberfläche zumindest eines Stützmittels eine im Wesentlichen ebene Fläche aufweist. Dies hat eine konstantere Anpresskraft zur Folge, was zur Erhöhung der Gleichmäßigkeit der Bewegung des anzutreibenden Elements führt.

Außerdem kann es günstig sein, dass zumindest eines der Stützmittel einen Vorsprungsabschnitt aufweist. Dieser ist vorzugsweise in der Mitte der der entsprechenden Stirnfläche des Oszillators im montierten Zustand des Ultraschallmotors zugewandten Fläche des Stützmittels angeordnet. Dadurch können Energieverluste reduziert werden. Hierbei ist es ebenso vorteilhaft, wenn der besagte vorzugsweise mittig angeordnete Vorsprungsabschnitt die jeweilige Stirnfläche des Oszillators in deren mittlerem oder zentralem Bereich im montierten Zustand des Ultraschallmotors kontaktiert.

Es kann vorteilhaft sein, dass die Anpressvorrichtung Rund- oder Flachfedern aufweist. Dies erweitert die konstruktiven Möglichkeiten des erfindungsgemäßen Motors.

Zudem kann es vorteilhaft sein, dass das anzutreibende Element als stabförmiger Körper ausgeführt ist, welcher in Längsrichtung angeordnete steife und weiche Platten und/oder Schichten in jeweils abwechselnder Reihenfolge aufweist. Dies unterbindet die Gefahr der parametrischen Eigenerregung des Systems, was die Betriebsstabilität des Motors erhöht und die vom Motor bedingten akustischen Geräusche verringert.

Weiterhin kann es vorteilhaft sein, dass das anzutreibende Element als ringförmiger Körper ausgeführt ist, welcher zumindest an einer seiner Stirnflächen mit einer schallisolierenden Zwischenlage in Kontakt steht, wobei sich an die schallisolierende Zwischenlage in axialer Richtung ein scheibenförmiges Halteelement anschließt. Auch durch diese Ausgestaltung des anzutreibenden Elements wird die Gefahr der parametrischen Eigenerregung des Systems unterbunden.

Ebenso kann es vorteilhaft sein, dass zumindest eines der Stützmittel in Anlageposition durch eine Fixierungsvorrichtung fixierbar ist, wobei besagte Fixierungsvorrichtung vorzugsweise zumindest eine Schraube und/oder einen Fixierbolzen und/oder eine Sperrklinke umfasst. Hierdurch lässt sich auf relativ einfache und kostengünstige Art und Weise eine Fixierung bzw. Befestigung der Stützmittel realisieren. Die Fixierung kann hierbei direkt oder indirekt erfolgen. Eine direkte Fixierung liegt beispielsweise vor, wenn diese durch direkten Angriff des Fixierungsmittels am Stützmittel realisiert ist, während eine indirekte Fixierung beispielsweise dadurch realisiert ist, dass das Fixierungsmittel am Gehäuse oder einem Gehäuseteil angreift, und durch die Fixierung des Gehäuses oder Gehäuseteils gleichzeitig eine Fixierung des einstückig mit dem Gehäuse oder Gehäuseteil ausgeführten Stützmittels resultiert. Neben der zuvor beschriebenen Befestigungsfunktion der Fixierungsvorrichtung kann dieser gleichzeitig die Funktion zukommen, das Stützmittel in die Anlageposition zu überführen.

Es kann von Vorteil sein, dass der piezoelektrische Ultraschallmotor weiterhin eine Erregervorrichtung des Oszillators aufweist, wobei die Erregervorrichtung als Generator ausgeführt ist, dessen Erregerfrequenz durch die Resonanzfrequenz des mit ihm verbundenen Oszillators bestimmt ist.

Ebenso kann es von Vorteil sein, dass die Erregervorrichtung des Oszillators ein selbsterregender Generator ist. Hierdurch kann die Erregerfrequenz des Oszillators stabilisiert werden.

Darüber hinaus kann es von Vorteil sein, dass die Erregervorrichtung des Oszillators einen spannungsgesteuerten Generator und einen Phasendetektor umfasst. Auch dies erlaubt die Stabilisierung der Erregerfrequenz des Oszillators.

Zudem kann es von Vorteil sein, dass eine Spannungsversorgung der Erregervorrichtung einen PWM-Controller aufweist, der einen analogen oder einen digitalen Steuereingang hat. Dies ermöglicht es, die Funktion des vorgeschlagenen Ultraschallmotors präzise mittels eines Controllers zu steuern. PWM steht hierbei für Pulsweitenmodulation oder Pulse Width Modulation.

Selbstverständlich sind auch Kombinationen der zuvor beschriebenen vorteilhaften Ausführungsformen möglich. Dabei sind auch Kombinationen denkbar, bei denen nur Teile der beschriebenen vorteilhaften Ausführungsformen miteinander kombiniert sind.

Die Erfindung wird nachfolgend anhand von Ausführungsbeispielen unter Zuhilfenahme von Figuren näher erläutert.

Es zeigen:
- Fig. 1: Schematische Darstellung einer ersten Ausführungsform des erfindungsgemäßen Ultraschallmotors
- Fig. 2: Schematische Darstellung der ersten Ausführungsform des erfindungsgemäßen Ultraschallmotors gemäß Fig. 1 in demontiertem Zustand
- Fig. 3: Schematische Darstellung einer weiteren Ausführungsform des erfindungsgemäßen Ultraschallmotors mit zwei gegenüberstehenden Oszillatoren
- Fig. 4: Schematische Darstellung der Verwendung des erfindungsgemäßen Ultraschallmotors als Rotationsmotor
- Fig. 5: Schematische Darstellung einer weiteren Ausführungsform des erfindungsgemäßen Ultraschallmotors aufweisend einen Zweiwellenoszillator
- Fig. 6: Schematische Darstellung unterschiedlicher Ausführungsformen der Stützmittel des erfindungsgemäßen Ultraschallmotors
- Fig. 7: Schematische Darstellung eines erfindungsgemäßen Ultraschallmotors mit von den jeweils zugeordneten Stirnflächen beabstandeten Stützmitteln (Darstellung 35) und mit in Anlageposition befindlichen Stützmitteln (Darstellung 36)
- Fig. 8: Verschiedene schematische Darstellungen (Darstellungen 38, 41, 42) zur Erläuterung des Arbeitsprinzips des erfindungsgemäßen Ultraschallmotors
- Fig. 9: Schematische Darstellung der Verformungen unterschiedlich ausgeführter Stützmittel mit akustisch beweglichen Abschnitten beim Betrieb des Ultraschallmotors
- Fig. 10: Blockschaltbild einer Ausführungsform der Erregervorrichtung
- Fig. 11: Blockschaltbild einer weiteren Ausführungsform der Erregervorrichtung
- Fig. 12: Blockschaltbild einer weiteren Ausführungsform der Erregervorrichtung mit PWM-Controller
- Fig. 13: Schematische Darstellung der Verwendung eines erfindungsgemäßen Ultraschallmotors in einem Zweikoordinatentisch
- Fig. 14: Schematische Darstellung der Verwendung eines erfindungsgemäßen Ultraschallmotors in einem weiteren Zweikoordinatentisch
- Fig. 15: Schematische Darstellung der Verwendung eines erfindungsgemäßen Ultraschallmotors für den Antrieb einer optischen Linsengruppe
- Fig. 16: Schematische Darstellung der Verwendung eines erfindungsgemäßen Ultraschallmotors in einem hochpräzisen geophysikalischen Theodoliten
- Fig. 17: schematische Darstellungen (Darstellungen 95, 96) weiterer Ausführungsformen des Gehäuses des erfindungsgemäßen Ultraschallmotors mit einstückig ausgeführten Stützmitteln

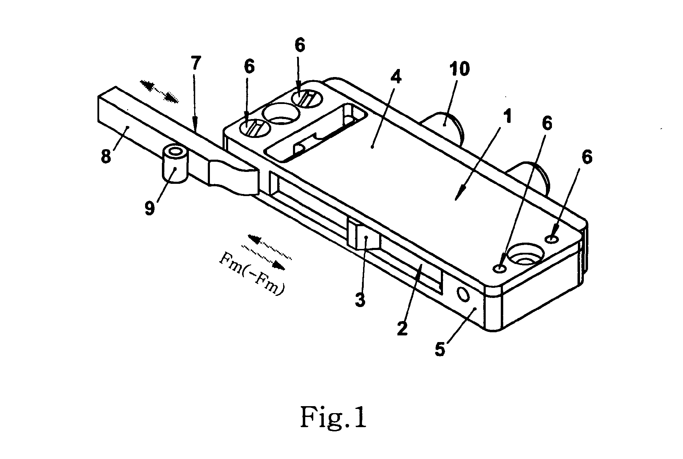

Fig. 1 zeigt einen Linearmotor als erste mögliche Ausführungsform des erfindungsgemäßen hochpräzisen Ultraschallmotors. Dieser besteht aus einem Gehäuse 1, das einen piezoelektrischen Ultraschalloszillator 2 beherbergt, an dem ein Friktionselement 3 angebracht ist. Das Gehäuse 1 umfasst zwei Gehäuseteile 4 und 5, wobei in Fig. 1 nicht zu erkennende Stützmittel zur Abstützung des Oszillators 2 an dessen Stirnflächen einstückig mit den Gehäuseteilen ausgeführt sind. Die Gehäuseteile 4 und 5 sind durch eine Fixierungsvorrichtung 6 in Form von Schrauben miteinander verbunden und fixiert, so dass gleichzeitig die einstückig mit diesen ausgeführten Stützmittel in einer in Anlage mit den jeweils zugeordneten Stirnflächen des Oszillators 2 befindlichen Position fixiert sind, so dass eine indirekte Fixierung der Stützmittel realisiert ist. Im erfindungsgemäßen Motor können auch andere Fixierungsvorrichtungen wie beispielsweise Fixierbolzen oder Sperrklinken (in Fig. 1 nicht dargestellt) genutzt werden.

Das Friktionselement 3 des Oszillators 2 ist dazu vorgesehen, mit einer Friktionsoberfläche 7 eines anzutreibenden Elements 8 in Kontakt zu gelangen, wobei das anzutreibende Element 8 durch Lager 9 gelagert und gehalten ist. In Fig. 1 ist nur aus Gründen einer übersichtlicheren Darstellung das anzutreibende Element 8 in Beabstandung zum Friktionselement 3 gezeigt; normalerweise jedoch liegt das anzutreibende Element 8 direkt über dem Friktionselement 3 und befindet sich mit diesem in Kontakt. Dabei wird durch eine Anpressvorrichtung 10 das anzutreibende Element 8 auf die Friktionsoberfläche 7 gepresst. Die Anpresskraft Fₚ muss etwa gleich 2Fₘ sein, wobei Fₘ die maximale durch den Motor entwickelte Kraft ist. Üblicherweise werden das Gehäuse 1 und die Lager 9 auf der Gerätegrundplatte, die nicht in den Figuren dargestellt ist, befestigt.

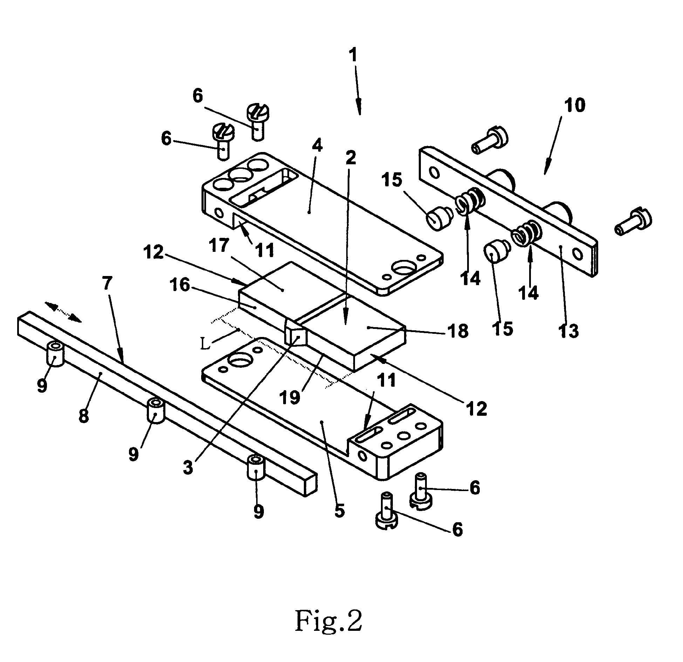

Aus Fig. 2 ist ersichtlich, dass jedes der Gehäuseteile 4 und 5 ein einstückig mit diesen ausgeführtes Stützmittel 11 aufweist, das in montiertem Zustand den Oszillator 2 an seinen bzw. den zugeordneten Stirnflächen 12 zumindest abschnittsweise kontaktiert und dabei abstützt. Die Anpressvorrichtung 10 umfasst einen Halter 13, Rundfedern 14 und Lager 15. Der Oszillator 2 des Motors ist als rechteckige piezoelektrische Platte 16 ausgeführt, die zwei Erregerelektroden 17, 18 und eine allgemeine Elektrode 19 aufweist. Die Oszillatorlänge L ist etwa gleich der Länge der in ihm erregten Welle, weshalb ein solcher Oszillator 2 nachfolgend als einwellig bezeichnet wird.

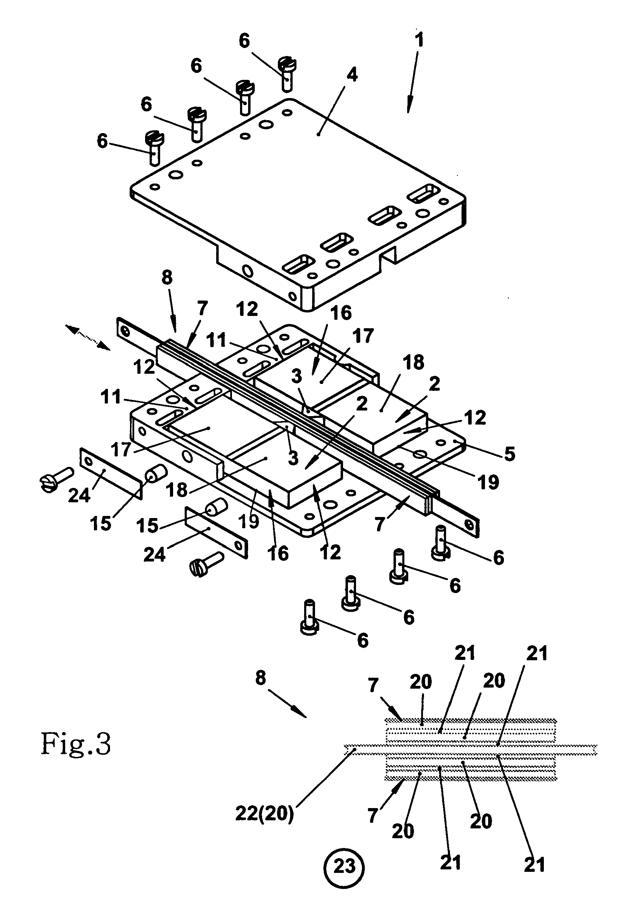

Fig. 3 zeigt eine weitere Ausführungsform des erfindungsgemäßen Ultraschallmotors, welcher zwei Oszillatoren 2 aufweist, die im Gehäuse 1 gegenüberliegend angeordnet sind. Das anzutreibende Element 8 dieses Motors weist eine Sandwichstruktur auf, und besteht aus in Längsrichtung angeordneten, sich jeweils abwechselnden steifen und weichen Schichten 20 und 21, die durch die zentrale elastische Platte 22 (siehe Darstellung 23 in Fig. 3) gehalten werden. Die Schichten 20 bestehen aus Oxidkeramik, Metall oder einem anderen harten Material. Es können auch poröse Materialien wie beispielsweise poröse Keramik oder poröses Metall verwendet werden. Die weichen Schichten 21 sind als dünne Schichten, beispielsweise aus einem Gummiwerkstoff oder einem thermoplastischen Kunststoff, ausgeführt und halten die Schichten 20 fest. Die Anpressvorrichtung 10 umfasst zwei Flachfedern 24.

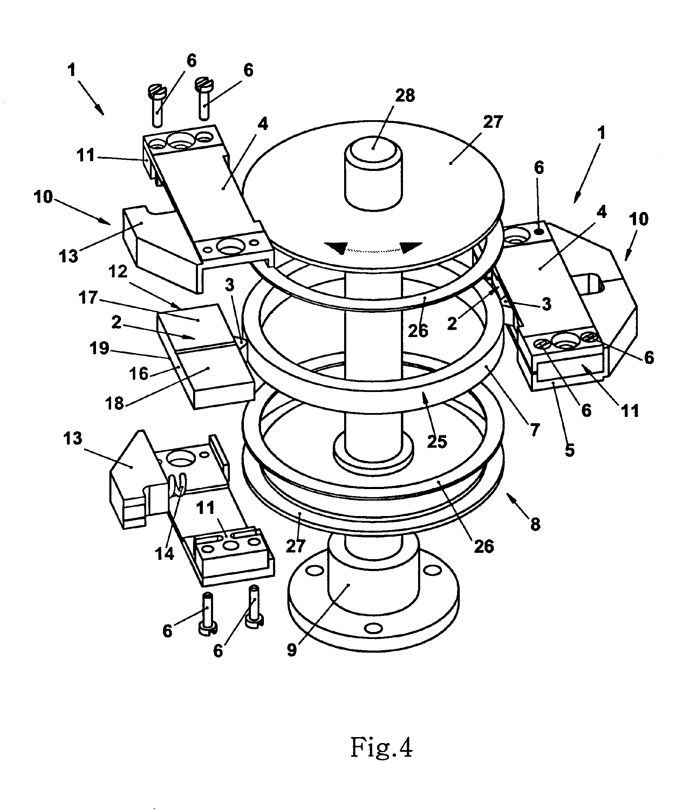

Fig. 4 stellt schematisch die Verwendung des erfindungsgemäßen Ultraschallmotors als Rotationsmotor dar. In diesem Motor werden zwei getrennte Gehäuse 1 verwendet, von denen jedes zwei Gehäuseteile 4 und 5 aufweist. In jedem der beiden Gehäuse 1 befindet sich ein Oszillator 2, an dem jeweils ein Friktionselement 3 angeordnet ist. Jedes Friktionselement 3 befindet sich in Kontakt mit der Friktionsoberfläche 7 des anzutreibenden Elements 8, welches aus einem harten, abriebfesten Ring 25 besteht. Gehalten wird der Ring 25 durch zwei gegenüberliegend angeordnete scheibenförmige Halter 27, wobei zwischen jedem der scheibenförmigen Halter 27 und dem Ring 25 eine schallisolierende Zwischenlage 26 angeordnet ist. Die scheibenförmigen Halter 27 sind mit einer Achse 28 befestigt, die im Lager 9 gelagert ist. Es ist ebenso möglich, dass der Ring 25 nur durch einen scheibenförmigen Halter 27 gehalten ist, wobei zwischen Ring 25 und scheibenförmigem Halter 27 ebenfalls eine schallisolierende Zwischenlage 26 angeordnet ist. Zudem ist es denkbar, dass nur ein Halter 27 existiert, der direkt mit dem Ring 25 verbunden ist, bzw. dass der eine Halter 27 einstückig mit dem Ring 25 ausgebildet ist. Weiterhin ist es denkbar, dass sich der Ring 25 wischen zwei Haltern 27 befindet, wobei die Halter 27 direkt mit dem Ring 25 verbunden sind bzw. die beiden Halter 27 und der Ring 25 einstückig ausgebildet sind.

Die Gehäuseteile 4 und 5 und die jeweils zugeordneten Stützmittel 11 beider Gehäuse sind als unabhängige, separate Teile ausgeführt. Dabei kann das Material, aus dem das Stützmittel gefertigt ist, einen Temperaturausdehnungskoeffizienten haben, der größer ist als der für das Material der Gehäuseteile 4 und 5. Durch die während der Montage stattfindenden Befestigung der beiden Gehäuseteile 4 und 5 mittels der Fixierungsvorrichtung 6 in Form von Schrauben erfolgt gleichzeitig die Fixierung der Stützmittel 11 in einer in Anlage mit den jeweils zugeordneten Stirnflächen 12 befindlichen Position.

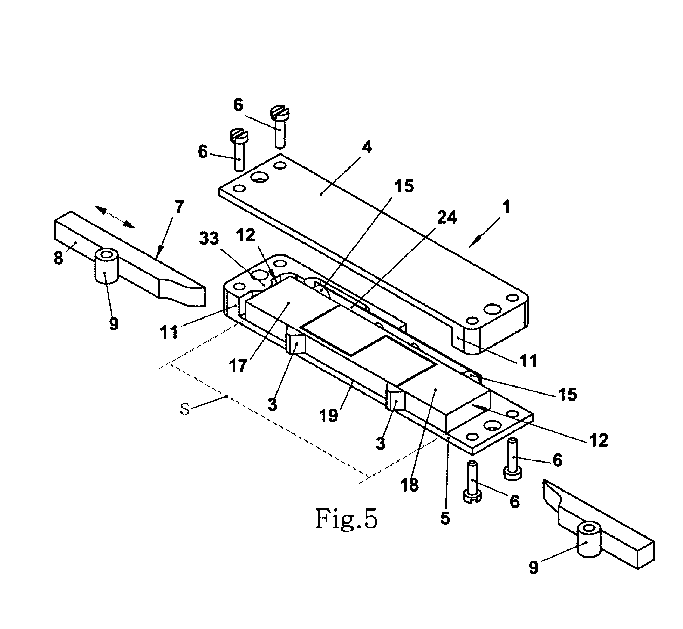

Fig. 5 zeigt eine weitere Ausführungsform des erfindungsgemäßen Ultraschallmotors mit einem Zweiwellenoszillator. Bei diesem Motor hat der Oszillator 2 die Länge S, die etwa gleich dem Zweifachen der in ihm erregten Wellenlänge beträgt. Zur Erregung der Welle weist der Oszillator 2 eine aufwändigere Konfiguration der Erregerelektroden 17 und 18 als der Einwellenoszillator gemäß den Fig. 1-4 auf. Auf dem Zweiwellenoszillator 2 sind zwei Friktionselemente 3 angeordnet. Die Anpressvorrichtung 10 dieses Motors umfasst eine Flachfeder 24. Die Stützmittel 11 sind einstückig mit den beiden Gehäuseteilen 4 und 5 ausgeführt. Hierbei weisen die Stützmittel 11 einen mittig oder zentral angeordneten Vorsprungsabschnitt 33 auf, der in montiertem Zustand des Ultraschallmotors die Stirnflächen 12 des Oszillators 2 ebenfalls in deren mittlerem oder zentralem Bereich kontaktiert.

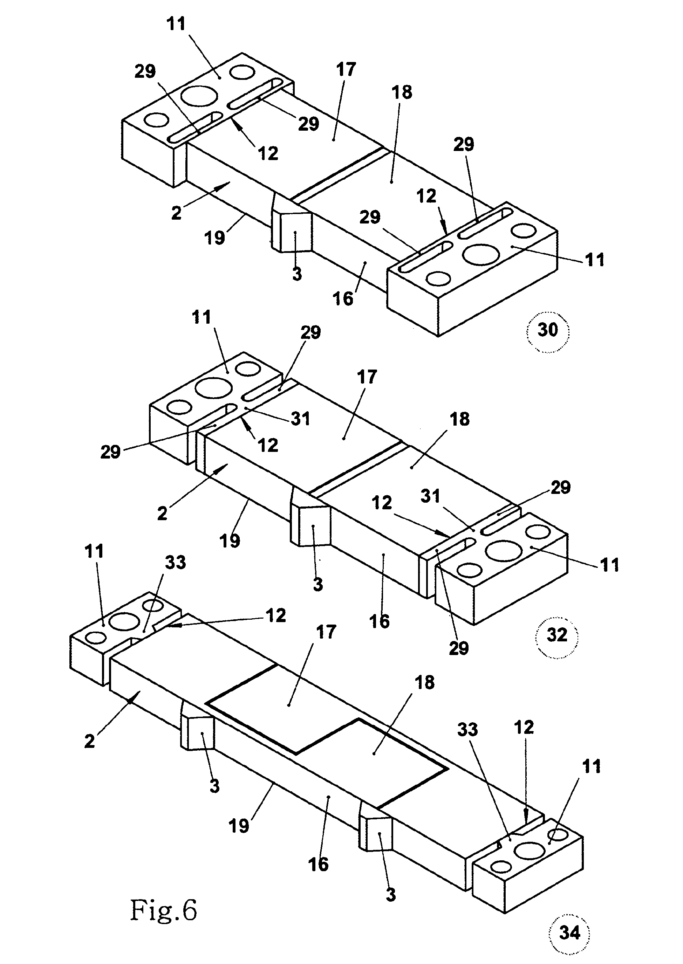

Fig. 6 zeigt verschiedene schematische Darstellungen von Ausführungsformen des Stützmittels 11. In den Darstellungen 30 und 32 von Fig. 6 umfasst das Stützmittel 11 jeweils zwei akustisch bewegliche Abschnitte 29, wobei diese in Darstellung 30 in Form einer Membran bzw. eines flachen Bandes ausgebildet sind. Dabei sind die akustisch beweglichen Abschnitte 29 einstückig mit dem Stützmittel 11 ausgebildet und jeweils an ihren Enden eingespannt, d.h. nicht frei, wobei sie an einem Ende kontinuierlich in einen zentralen Steg des Stützmittels 11 übergehen und am gegenüberliegenden anderen Ende kontinuierlich in den Randbereich des Stützmittels 11 übergehen. Durch diese Ausgestaltung ergibt sich ein beidseitig geschlossener Schlitz innerhalb des Stützmittels 11.

Wie aus Darstellung 30 der Fig. 6 ersichtlich sind die akustisch beweglichen Abschnitte 29 in montiertem Zustand des Ultraschallmotors mit dessen zugeordneten Stirnflächen 12 in Kontakt. Gemäß Darstellung 32 der Fig. 6 umfasst das dort gezeigte Stützmittel 11 ebenfalls zwei einstückig mit dem Stützmittel 11 ausgeführte akustisch bewegliche Abschnitte 29, wobei hier jedoch nur ein Ende eingespannt ist, während das entsprechend andere Ende frei ist. Hierbei geht das eingespannte Ende kontinuierlich in einen zentralen Steg des Stützmittels 11 über. Zusammen mit besagtem zentralen Steg ergeben die beiden gemäß Darstellung 32 ausgeführten akustisch beweglichen Abschnitte 29 im Wesentlichen die Form einer aufgerollten Stimmgabel 31 mit auseinandergespreizten Schenkeln, wobei die akustisch beweglichen Abschnitte 29 oder Schenkel im montierten Zustand des Ultraschallmotors in Kontakt mit der Stirnfläche 12 des Oszillators 2 stehen. Die Oberfläche der Stützmittel 11, welche die Stirnflächen 12 des Oszillators 2 im montierten Zustand berühren, kann eine im Wesentlichen ebene Fläche sein wie in den Darstellungen 30 und 32 der Fig. 6 gezeigt.

Bei Verwendung von Zweiwellenoszillatoren 2 können Stützmittel 11 verwendet werden, die einen Vorsprungsabschnitt 33 aufweisen, welcher die Stirnfläche 12 des Oszillators 2 in montiertem Zustand des Ultraschallmotors, wie in Darstellung 34 der Fig. 6 gezeigt, berührt. Der Vorsprungsabschnitt 33 ist dabei mittig oder zentral auf der der Stirnfläche 12 des Oszillators 2 zugewandten Fläche des Stützmittels 11 angeordnet, und kontaktiert den Oszillator 2 im mittleren oder zentralen Bereich der entsprechenden Stirnfläche 12.

Im erfindungsgemäßen Ultraschallmotor können die beiden Gehäuseteile 4 und 5 gleiche Geometrie und gleiche Abmessungen, wie in den Fig. 1-5 dargestellt, aufweisen.

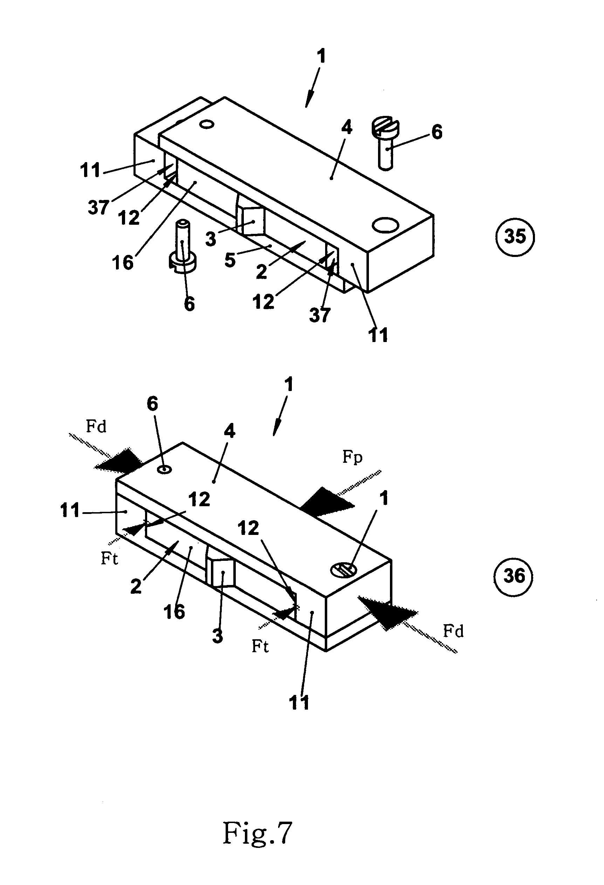

Fig. 7 zeigt schematisch einen erfindungsgemäßen Ultraschallmotor, bei dem gemäß Darstellung 35 die beiden Gehäuseteile 4 und 5 in unmontiertem, d.h. nicht fixiertem Zustand dargestellt sind und sich dementsprechend die einstückig mit den Gehäuseteilen ausgeführten Stützmittel 11 in beabstandeter Position oder Abstandsposition zu den jeweils zugeordneten Stirnflächen 12 des Oszillators 2 befinden. Bei vorliegender Abstandsposition gemäß Darstellung 35 existiert zwischen den Stützmitteln 11 und den zugeordneten Stirnflächen 12 ein Spalt 37, welcher bei Vorliegen einer Anlageposition gemäß Darstellung 36, bei der sich die Stützmittel 11 in Kontakt mit den zugeordneten Stirnflächen 12 befinden, nicht mehr vorhanden und dadurch rückgebildet ist. In Anlageposition erfolgt durch die Fixierungsvorrichtung 6 in Form einer Schraube die Fixierung der Gehäuseteile 4 und 5 und mit ihnen die Fixierung der einstückig mit den Gehäuseteilen 4 und 5 ausgeführten Stützmittel 11. Während der Montage des Ultraschallmotors werden an die Gehäuseteile 4 und 5 die Kräfte F_{d} angelegt. Durch die Anpressvorrichtung 10 wirkt auf den Oszillator 2 die Kraft Fₚ. Zwischen den Stirnflächen 12 des Oszillators 2 und den Stützmitteln 11 entsteht die Reibungskraft Fₜ. Die auf den Oszillator 2 von der Seite des anzutreibenden Elements 8 einwirkende Kraft stellt die Reaktion auf Kraft Fₚ dar, die in Fig. 7 nicht dargestellt ist.

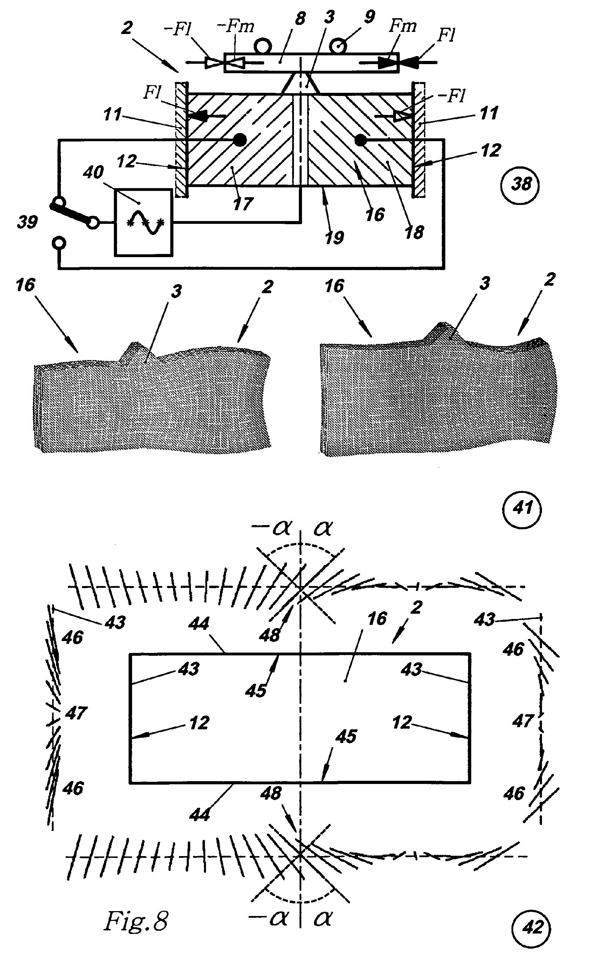

Darstellung 38 der Fig. 8 zeigt einen Einwellenoszillator 2, der durch einen Umschalter 39 mit einer Erregervorrichtung 40 verbunden ist. Darstellung 41 von Fig. 8 zeigt Bilder der maximalen Deformation des Oszillators 2. Darstellung 42 der Fig. 8 zeigt Bewegungsbahnen von Oberflächenpunkten 43 der Stirnflächen 12 der Platte 16 des Oszillators 2 und Bewegungsbahnen von Oberflächenpunkten 44 von Seitenflächen 45 einer Platte 16 des Oszillators 2. Die Amplituden der Bewegungsbahnen haben ihr Maximum am Rand der Oberflächen 43 der Stirnflächen 12 und ihr Minimum 47 im zentralen oder mittleren Teil der Oberfläche 43 der Stirnflächen 12. Zusätzlich haben die Amplituden der Bewegungsbahnen Maxima 48 im zentralen oder mittleren Teil der Oberfläche 44 der Seitenflächen 45. Die Bewegungsbahnen der sich im Zentrum der Oberflächen 44 befindlichen Punkte sind zu diesen Oberflächen um den Winkel α geneigt.

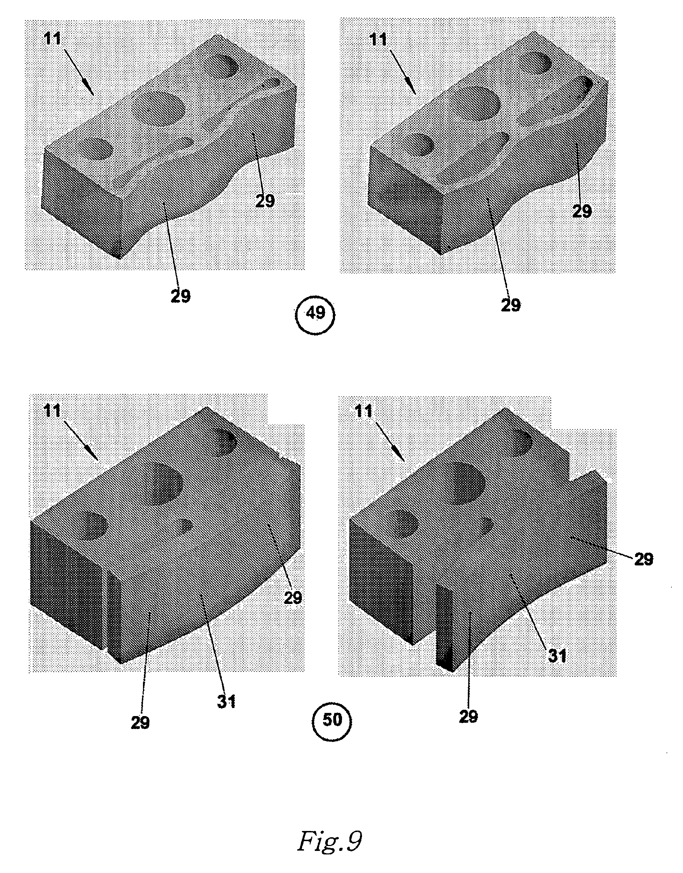

Darstellung 49 der Fig. 9 zeigt Deformationsbilder des Stützmittels 11 mit zwei einstückig mit diesem ausgeführten, an beiden Enden eingespannten akustisch beweglichen Abschnitten 29 zum Zeitpunkt der maximalen Deformation des Oszillators 2 (siehe Fig. 8). Darstellung 50 der Fig. 9 zeigt Deformationsbilder von akustisch beweglichen Abschnitten 29, die jeweils an einem Ende über eine einstückige Verbindung eingespannt und am gegenüberliegenden, anderen Ende frei sind. Hierbei ist ebenso der Zeitpunkt der maximalen Deformation des Oszillators 2 (siehe Fig. 8) dargestellt.

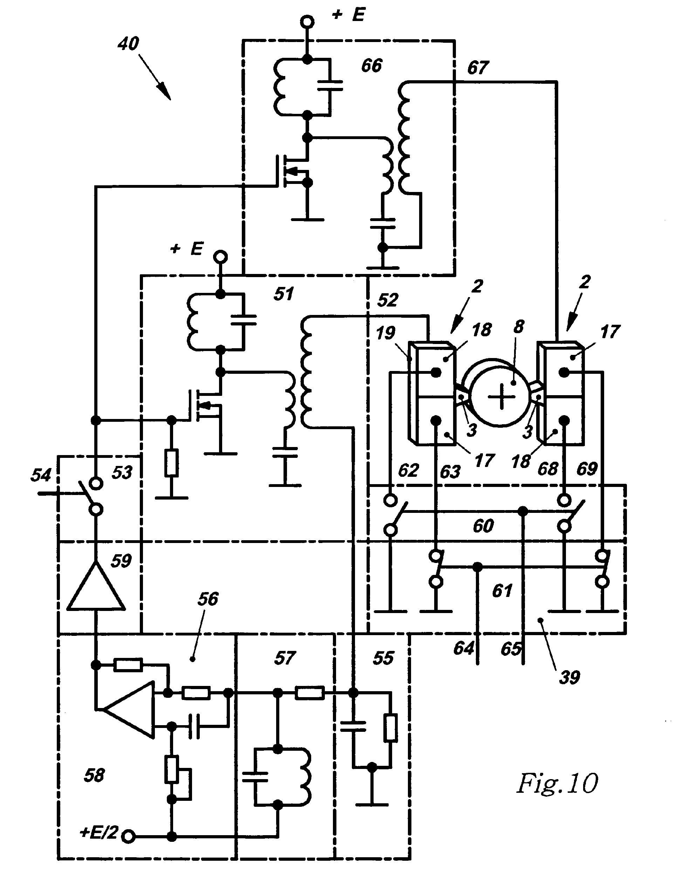

Fig. 10 zeigt ein Blockschaltbild der Erregervorrichtung 40 des Oszillators 2 einschließlich der elektrischen Bauteile. Die Blockschaltung besteht aus einem Leistungsverstärker 51 mit einem Ausgang 52, einem Ausschalter 53 mit einem Steuereingang 54, einem Rückkopplungselement 55, einem Rückkopplungskreis 56 und einem Umschalter 39. Der Rückkopplungskreis 56 kann aus einem Filter 57 im Rückkopplungskreis, einem Phasenschieber 58 und einem Verstärker 59 für das Rückkopplungssignal bestehen. Der Umschalter 39 besteht aus Schaltern 60, 61 mit umschaltbaren Ausgängen 62, 63 und Steuereingängen 64, 65. Wenn der erfindungsgemäße Motor einen zweiten Oszillator 2 oder mehrere zusätzliche Oszillatoren 2 aufweist, kann die Blockschaltung einen zweiten Leistungsverstärker 66 mit einem Ausgang 67 aufweisen, wobei der Umschalter 39 zusätzliche umschaltbare Ausgänge 68, 69, wie in Fig. 10 dargestellt, haben kann. Die Spannungsversorgung der Erregervorrichtung 40 erfolgt durch die elektrische Spannung E.

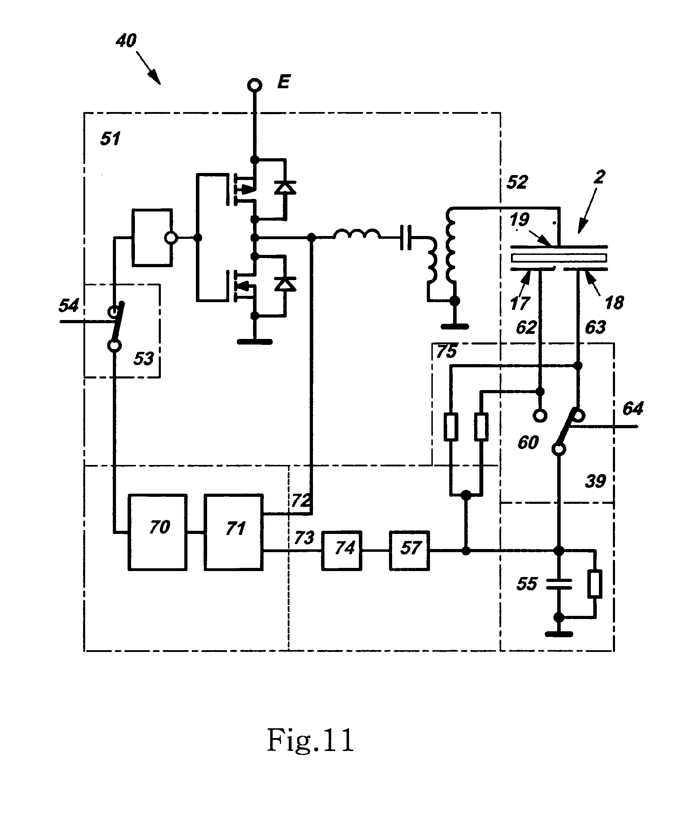

Fig. 11 zeigt das Blockschaltbild einer anderen Ausführungsform der Erregerschaltung 40. In dieser Ausführungsform besteht der Rückkopplungskreis 56 aus einem spannungsgesteuerten Generator 70 und einem Phasendetektor 71 mit einem Stützeingang 72 und einem Messeingang 73. Der Messeingang 73 kann über einen Komporator 74 und einen Filter 57 mit dem Rückkopplungselement 55 oder über einen Entkoppelwiderstand 75 mit der Elektrode 17, 18 des Oszillators 2 verbunden sein.

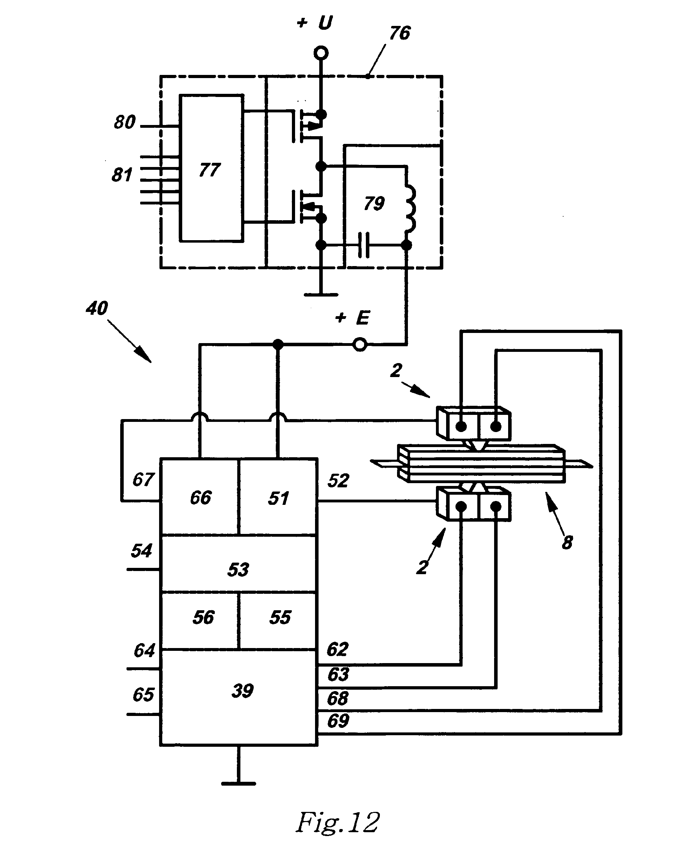

In einer weiteren Ausführungsform kann die Erregervorrichtung 40 einen PWM-Controller einer Spannungsversorgung 76 aufweisen, wie dies beispielsweise in Fig. 12 dargestellt ist. Der Controller kann einen digitalen PWM-Modulator 77, einen Leistungsverstärker 78 und einen Filter 79 umfassen. Der PWM-Controller kann einen analogen Steuereingang 80 oder einer Gruppe digitaler Steuereingänge 81 aufweisen. Die Spannungsversorgung des Controllers 76 erfolgt durch die elektrische Spannung U.

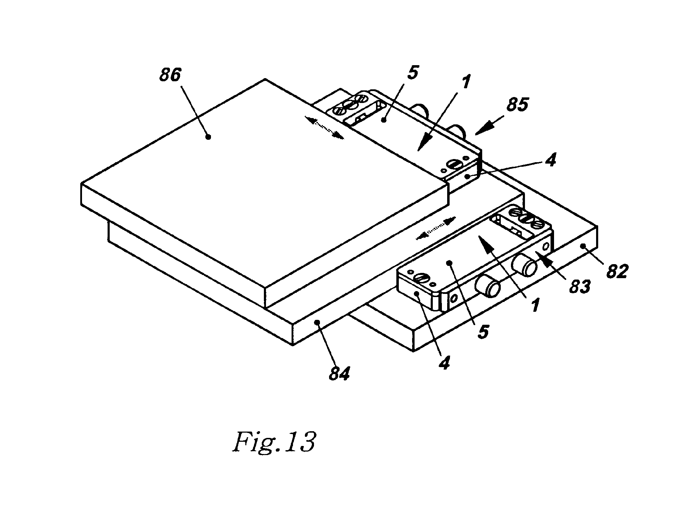

Fig. 13 zeigt als Anwendungsbeispiel für den erfindungsgemäßen Ultraschallmotor schematisch einen hochpräzisen linearen Zweikoordinatentisch. Der Tisch besteht aus einer Grundplatte 82, auf der ein erster Ultraschallmotor 83 angeordnet ist. Dieser Motor bewirkt eine Linearbewegung der Zwischenplattform 84. Auf dieser Zwischenplattform 84 befindet sich ein zweiter Ultraschallmotor 85. Dieser Motor bewirkt eine Linearbewegung der technologischen Plattform 86.

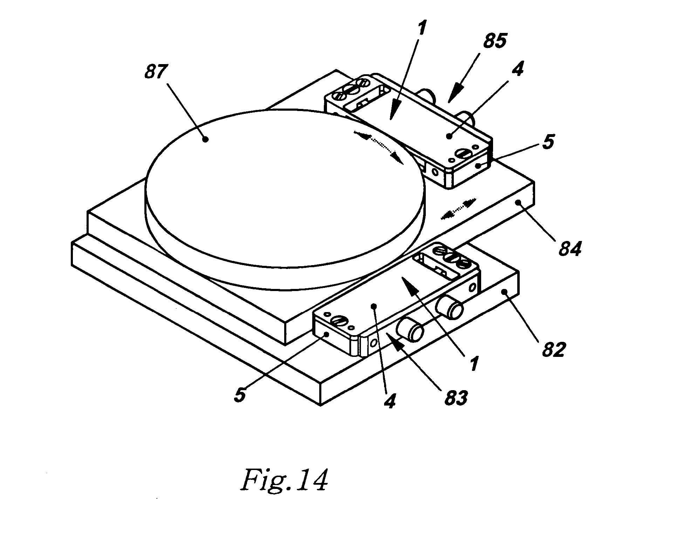

Fig. 14 zeigt als weiteres Anwendungsbeispiel für den erfindungsgemäßen Ultraschallmotor schematisch einen hochpräzisen Tisch mit einer drehbaren Plattform 87.

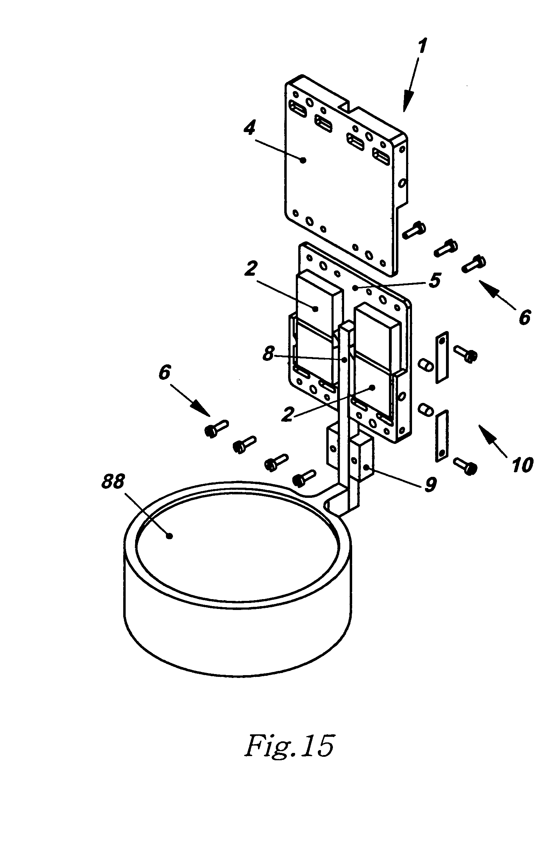

Fig. 15 zeigt ein weiteres Anwendungsbeispiel für den erfindungsgemäßen Ultraschallmotor, wobei hier schematisch seine Verwendung als Antrieb einer optischen Linsengruppe 88 dargestellt ist.

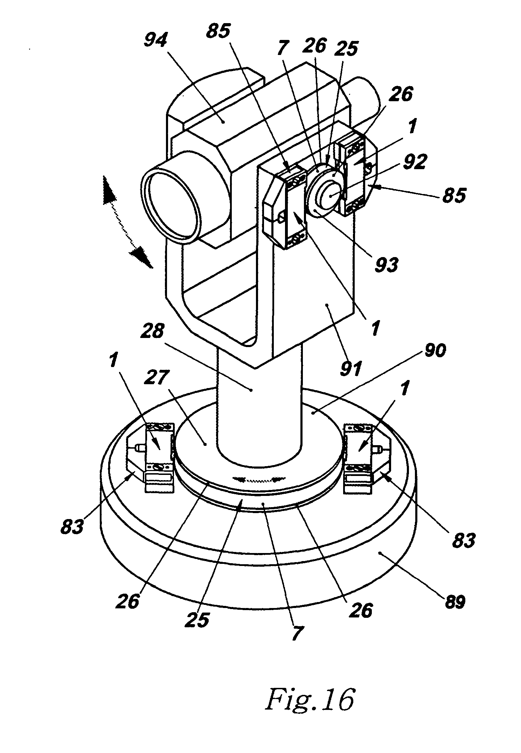

Fig. 16: zeigt die Verwendung des erfindungsgemäßen Ultraschallmotors in einem hochpräzisen geophysikalischen Theodoliten. Der Theodolit umfasst eine Grundplatte 89, auf der eine erste sich drehende Achse 28 angeordnet ist. Auf der Achse 28 ist ein erster Rotor 90 befestigt, der durch zwei gegenüberstehend angeordnete Ultraschallmotoren 83 in Drehung versetzt wird.

Außerdem sitzt auf der Achse 28 ein Halter 91, in dem horizontal eine zweite sich drehende Achse 92 angeordnet ist. Auf der Achse 92 ist ein zweiter Rotor 93 befestigt, der durch die zwei gegenüberstehend angeordneten Ultraschallmotoren 85 in Drehung versetzt wird. Die Achse 92 hält das optische Objektiv 94 des Theodoliten.

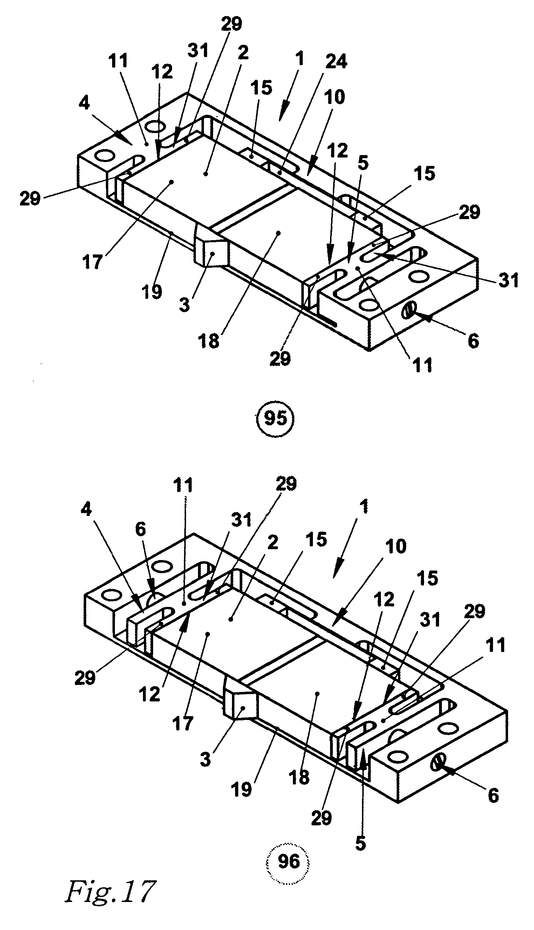

Fig. 17 zeigt in den Darstellungen 95 und 96 weitere Ausführungsformen des Gehäuses des erfindungsgemäßen Ultraschallmotors. Gemäß Darstellung 95 ist das Gehäuse 1 hierbei einteilig und weist zwei einstückig mit diesem ausgeführte Stützmittel 11 auf. Das Stützmittel 11 auf der linken Seite der Darstellung 95 umfasst zwei akustisch bewegliche Abschnitte 29, die jeweils als einseitig freier Schenkel ausgeführt sind, und hat im Wesentlichen die Form einer aufgerollten Stimmgabel mit auseinandergespreizten Schenkeln. Das Stützmittel 11 auf der gegenüberliegenden Seite (rechte Seite der Darstellung 95) umfasst ebenso zwei akustisch bewegliche Abschnitte 29, die ebenfalls jeweils als einseitig freier Schenkel ausgeführt sind. Im Unterschied zum Stützmittel 11 auf der linken Seite der Darstellung 95 befindet sich im sich dem Stützmittel in dem Oszillator 2 abgewandter Richtung anschließenden Teil des Gehäuses 1 eine beidseitig geschlossene, schlitzförmige Aussparung, in die der Endbereich der Fixierungsvorrichtung 6 in Form einer Schraube hineinragt. Durch die besagte schlitzförmige Aussparung hat das Stützmittel 11 in Draufsicht im Wesentlichen die Form eines Doppel-T-Trägers bzw. eine H-Form. Gehalten und geführt ist die Schraube durch ein Gewinde im äußersten Bereich des Gehäuses 1. Die Schraube ist endseitig in Kontakt mit dem Stützabschnitt 11. Durch Drehen der Schraube lässt sich diese in Richtung des Stützmittels 11 bewegen, so dass das Stützmittel in Richtung des Oszillators 2 verschoben oder bewegt werden kann.

Gegenüber dem Gehäuse 1 aus Darstellung 95 der Fig. 17 schließt sich beim Gehäuse gemäß Darstellung 96 der Fig. 17. bei beiden Stützmitteln 11 in dem Oszillator 2 jeweils abgewandter Richtung eine schlitzförmige Aussparung an, die auf einer Seite offen ist. Jeweils befindet sich das Fixierungsmittel 6 in Form einer Schraube endseitig in Kontakt mit dem Stützmittel 11. Die Stützmittel 11 weisen in Draufsicht im Wesentlichen die Form eines Doppel-T-Trägers bzw. eine H-Form auf.

Nachfolgend wird die Funktionsweise des erfindungsgemäßen Ultraschallmotors näher erläutert.

Im demontierten Zustand des Gehäuses 1, d.h. in Abstandsposition (siehe Darstellung 35, Fig. 7), existiert zwischen den Stützmitteln 11 und den Stirnflächen 12 des Oszillators 2 ein Spalt 37. Bei der Montage des Gehäuses 1 werden an die Gehäuseteile 4 und 5 zwei entgegengesetzt gerichtete Kräfte F_{d} angelegt, wie aus Darstellung 36 der Fig. 7 ersichtlich. Die Größe der Kraft F_{d} muss gleich oder größer der vom Motor maximal entwickelten Kraft Fₘ sein. Die Kräfte F_{d} bewirken, dass die einstückig mit den Gehäuseteilen 4 und 5 verbundenen Stützmittel 11 an die zugeordneten Stirnflächen 12 des Oszillators 2 angepresst werden, wodurch der Spalt 37 rückgebildet wird und verschwindet. Danach werden die Gehäuseteile 4 und 5 durch die Fixierungsvorrichtung 6 miteinander verbunden und fixiert, womit gleichzeitig die Stützmittel 11 in der Anlageposition fixiert sind, was einer indirekten Fixierung der Stützmittel entspricht. Die Gehäuseteile 4 und 5 können auch auf andere Weise miteinander verbunden werden, beispielsweise mit Hilfe von Fixierbolzen oder Sperrklinken. Das hat zur Folge, dass jedes der Stützmittel 11 durch die Kraft F_{d} an die Stirnfläche 12 des Oszillators 2 angepresst ist.

Beim Verbinden der Erregervorrichtung 40 mit der Erregerelektrode 17 des Oszillators 2 (siehe Darstellung 38, Fig. 8) beginnt die Vorrichtung eine Spannung bereitzustellen, deren Frequenz gleich der Arbeitsfrequenz des Oszillators 2 ist. Diese Frequenz entspricht der Resonanzfrequenz der asymmetrischen Schwingungen des Oszillators 2. Dabei beginnt die Platte 16 des Einwellenoszillators 2 so zu schwingen (d.h. sie deformiert sich), wie in Darstellung 41 der Fig. 8 dargestellt. Die Oberflächenpunkte 43 und 44 der Stirnflächen 12 und der Seitenflächen 45 bewegen sich auf den in Darstellung 42 der Fig. 8 gezeigten geraden Bewegungsbahnen.

Die Schwingungen der Oberflächen 43 der Stirnflächen 12 werden auf die diese kontaktierenden Stützmittel 11 übertragen. Da sich die Maxima 46 der Amplituden der Bewegungsbahnen im Bereich der akustisch beweglichen Abschnitte 29 befinden, und die Minima 47 der Amplituden der Bewegungsbahnen sich in den zentralen oder mittleren Bereichen der Stützmittel 11 befinden, schwingen die Stützmittel so wie in den Darstellungen 49, 50 der Fig. 9 gezeigt. Hierbei kommt es zu keiner deformierenden Einwirkung auf den Oszillator 2.

Die Ultraschallschwingungen der Stützmittel 11 führen zu einer Verringerung des dynamischen Reibungskoeffizienten zwischen den Stützmitteln 11 und der Oberfläche 43 der Stirnflächen 12 des Oszillators 2. Außerdem wird die Verringerung des Reibungskoeffizienten durch die ebene Fläche der Stützmittel 11, die mit den Stirnflächen 12 des Einwellenoszillators 2 in Kontakt steht, unterstützt, wie dies aus den Darstellungen 30 und 32 der Fig. 6 bzw. aus den Fig. 1-4 ersichtlich wird.

Zusätzlich können die Flächen 43 der Stirnflächen 12 des Oszillators 2 mit Öl, Graphit, Molybdänsulfid oder einem anderen Antifriktionsmaterial bedeckt bzw. beaufschlagt sein. Dadurch überschreitet der Reibungskoeffizient für die Paarung der vorzugsweise aus Kunststoff gefertigten Stützmittel 11 und der Piezokeramik, aus denen der Oszillator 2 hergestellt ist, den Wert von 0,05 nicht. Das bedeutet, dass die Kraft Fₜ (siehe Darstellung 36 der Fig. 7) zwischen den Stützmitteln 11 und dem Oszillator 2 etwa 0,05 F_{d} oder 0,05 Fₘ oder 0,1 Tₚ beträgt. Das bedeutet, dass das Klemmen des Oszillators 2 durch die Stützmittel 11 das Wirken der Anpresskräfte Fₚ praktisch nicht verhindert.

Das im zentralen oder mittleren Teil der Oberfläche 44 der Seitenfläche 45 des Oszillators 2 befestigte Friktionselement 3 schwingt auf einer geneigten Bewegungsbahn, deren Neigungswinkel gleich α (siehe Darstellung 42, Fig. 8) ist. Dieses überträgt auf das anzutreibende Element 8 die Kraft Fₘ, die in Richtung der Erregerelektrode wirkt. Diese Kraft wirkt auf die Motorlast (Last ist in der Fig. 8 nicht dargestellt). Dadurch entsteht eine entgegenwirkende Kraft - Fₗ. Diese Kraft presst die linke Stirnfläche 12 des Oszillators 2 an das linke Stützmittel 11 (siehe Darstellung 38, Fig. 8). Beim Umschalten mit dem Umschalter 39 der Erregervorrichtung 40 von der Elektrode 17 zur Elektrode 18 ändert sich das Vorzeichen des Neigungswinkel α der Bewegungsbahn auf -α. Dadurch ändern die Kräfte Fₘ und Fₗ ihr Vorzeichen (-Fₘ und -Fₗ). In diesem Fall presst die Kraft Fₗ die rechte Stirnfläche 12 des Oszillators 2 an das rechte Stützmittel 11.

Da der Oszillator 2 durch die Stützmittel 11 mittels der Kraft F_{d}, die gleich oder größer als die vom Motor entwickelte Kraft Fₘ ist, gehalten wird, entsteht beim Umschalten der Erregervorrichtung 40 kein Spalt 37, und es erfolgt daher auch keine Verschiebung des Oszillators 2 bezogen auf seine Ausgangslage. Das bedeutet, dass im vorgeschlagenen Motor keine mechanische Hysterese auftritt bzw. diese zumindest vernachlässigbar ist. Da die Stützmittel 11 in ihrem zentralen oder mittleren Bereich eine hohe Längssteifigkeit aufweisen, hat auch der Motor selbst eine hohe Längssteifigkeit. Diese Steifigkeit erreicht Werte von 10 N/µm. Diese beiden Eigenschaften des vorgeschlagenen Ultraschallmotors werden de facto automatisch bei der Montage garantiert. Deshalb ist keine besondere Genauigkeit bei der Herstellung der Teile des Gehäuses 1 und des Oszillators 2 erforderlich. Die hohe Passgenauigkeit der Abmessungen wird durch die neue Motorkonstruktion bei seiner Montage gesichert.

Wenn im Motor ein Zweiwellenoszillator 2 mit zwei Friktionselementen 3 eingesetzt wird, können Stützmittel 11 verwendet werden, die einen zentral oder mittig angeordneten Vorsprungsabschnitt 33 haben (siehe Darstellung 34, Fig. 6). Dies ändert nicht das Funktionsprinzip des Ultraschallmotors. Da keine passgenau gefertigten Teile erforderlich sind, wird die Herstellung des Motors vereinfacht und insgesamt eine Kostenreduktion erzielt.

Die einstückige Ausführung der Gehäuseteile 4 und 5 und der Stützmittel 11 bei gleicher Geometrie und gleichen Abmessungen ermöglicht die Vereinfachung der Technologie zur Herstellung des erfindungsgemäßen Ultraschallmotors.

Die Herstellung der Gehäuseteile 4 und 5 und der Stützmittel 11 als voneinander unabhängige, d.h. separate Teile, ermöglicht es, die Stützmittel 11 aus einem Material zu fertigen, das einen höheren Temperaturausdehnungskoeffizienten aufweist als der Temperaturausdehnungskoeffizient des Materials, aus dem die Gehäuseteile 4 und 5 bestehen. Beispielsweise können die Stützmittel 11 aus einem Kunststoff und die Gehäuseteile 4 und 5 aus Aluminium gefertigt werden. Dies ermöglicht es, den Effekt des Klemmens des Oszillators 2 durch das Gehäuse 1 bei einer wesentlichen Absenkung der Umgebungstemperatur oder das Entstehen eines Spaltes zwischen dem Oszillator 2 und den Stützmitteln 11 bei einer wesentlichen Erhöhung der Umgebungstemperatur zu vermeiden bzw. deutlich zu reduzieren.

Die Ausführung des anzutreibenden Elements 8 im erfindungsgemäßen Ultraschallmotor als Stab, bestehend aus in Längsrichtung angeordneten und sich jeweils abwechselnden steifen und weichen Platten und/oder Schichten ermöglicht es, die Amplitude der im anzutreibenden Element 8 erzeugten Ultraschallschwingungen wesentlich zu senken.

Die Ausführung des anzutreibenden Elementes 8 als Ring 25, der mittels zumindest eines scheibenförmigen Halters 27 über wenigstens eine schallisolierende Zwischenlage 26 gehalten wird, ermöglicht es, die Ausbreitung der Ultraschallschwingungen in der Achse 28 des entsprechend vorgeschlagenen Motors zu unterbinden.

Durch die beiden zuvor beschriebenen Ausführungen ist es möglich, den Effekt der parametrischen Erregung des Schwingungssystems Oszillator-anzutreibendes Element auszuschließen oder zumindest stark zu reduzieren, wodurch sich die Betriebstabilität des erfindungsgemäßen Motors erhöht und die durch den Motor erzeugten Geräusche verringert werden.

Durch den Einsatz von Rundfedern 14 in der Anpressvorrichtung 10 ist es möglich, die Konstanz der Anpresskraft zu erhöhen.

Durch den Einsatz von Flachfedern 24 in der Anpressvorrichtung 10 ist es möglich, die Motorabmessungen zu verringern.

Da im erfindungsgemäßen Ultraschallmotor der Oszillator 2 nicht durch die Stützmittel 11 deformiert wird, kann die Erregervorrichtung 40 des Oszillators 2 als selbsterregender Generator ausgeführt werden, dessen Erregerfrequenz durch die Resonanzfrequenz des mit ihm verbundenen Oszillators für Ultraschallschwingungen bestimmt wird, siehe Fig. 10. Zur Realisierung dieses Prinzips wird die Frequenzabhängigkeit der Phasenverschiebung des durch den Oszillator fließenden Stroms im Verhältnis zur Erregerspannung bestimmt. Diese Abhängigkeit hat eine Null-Phasenverschiebung im mechanischen Resonanzpunkt des Oszillators 2.

Nachfolgend wird das Funktionsprinzip einer derartigen Erregervorrichtung 40 näher erläutert.

Beim Anlegen der Versorgungsspannung E fließt über den Oszillator 2 ein Stromimpuls, wodurch der Oszillator 2 bei seinen Resonanzfrequenzen zu schwingen beginnt. Dadurch erscheint am Rückkopplungselement 55 eine dem durch den Oszillator 2 fließenden Strom proportionale Rückkopplungsspannung, die das Rückkopplungssignal darstellt. Diese Spannung gelangt auf den Eingang des Rückkopplungskreises 56, wo sie durch ein Filter gefiltert wird. Das Filter trennt die der Arbeitsfrequenz entsprechende Harmonische des Oszillators 2 heraus. Außerdem wird die Spannungsphase durch den Phasenschieber 58 verschoben und die Amplitude durch den Verstärker 59 verstärkt. Danach wird die Spannung auf den Eingang des Leistungsverstärkers 51 gegeben, verstärkt und gelangt von dem Ausgang 52 des Leistungsverstärkers 51 auf den Oszillator 2. Dadurch wird der Prozess der Eigenerregung der Vorrichtung angestoßen.

Die Schaltung wird so ausbalanciert, dass auf der Betriebsfrequenz des Oszillators 2 der Winkel der Phasenverschiebung im Rückkopplungskreis gleich Null und der Verstärkungskoeffizient größer 1 ist. Deshalb stellt die in Fig. 10 dargestellte Erregervorrichtung 40 einen selbsterregenden Generator dar, der auf der Arbeitsfrequenz des Oszillators schwingt. Das Ausbalancieren der Schaltung erfolgt mit Hilfe des Phasenschiebers 58 und des Verstärkers 59 des Rückkopplungskreises 56.

Es kann auch ein anderes Prinzip genutzt werden, um die Arbeitsfrequenz der Erregervorrichtung 40 gleich der der Resonanzfrequenz des Oszillators 2 zu halten. In diesem Fall kann der Rückkopplungskreis 56 der Erregervorrichtung einen spannungsgesteuerten Generator 70 und einen Phasendetektor 71 aufweisen, wie in Fig. 11 dargestellt. Eine derartige Erregervorrichtung arbeitet nach folgendem Funktionsprinzip.

Beim Anlegen der Versorgungsspannung E beginnt der spannungsgesteuerte Generator 70 auf einer nahe zur Resonanzfrequenz des Oszillators 2 liegenden Frequenz zu schwingen. Zu Beginn schwingt der Oszillator 2 auf dieser Frequenz. Am Rückkopplungselement 55 oder an der freien Elektrode 17, 18 bildet sich eine Rückkopplungsspannung aus. Diese Spannung gelangt über das Filter 57 auf den Komporator 74. Der Komporator 74 erzeugt eine Rechteckspannung, die auf den Messeingang 73 des Phasendetektors 71 geleitet wird. Am Stützeingang 72 des Phasendetektors 71 liegt eine Rechteckstützspannung an.

Im Ergebnis liegen an den zwei Eingängen 72 und 73 zwei Rechteckspannungen an, deren Phasenverschiebung untereinander das Fehlersignal bestimmt, welches am Ausgang des Phasendetektors 71 liegt. Dieses Signal gelangt auf den Eingang des Generators 70 und steuert über die Frequenz seine Erregung und zwar verschiebt er sie so, dass sie immer gleich der Resonanzfrequenz des Oszillators 2 ist.

In dieser Ausführungsform können der Generator 70 und der Phasendetektor 71 elektronische Analogbauteile enthalten. Außerdem können der Generator 70 und der Phasendetektor 71 eine feste Logik oder mikroprozessorgesteuerte digitale Bauelemente enthalten.

Wenn einer oder mehrere zusätzliche Oszillatoren 2 eingesetzt werden, kann die Erregervorrichtung 40 einen zusätzlichen Leistungsverstärker 66 enthalten, dessen Ausgang 67 mit dem zusätzlichen Oszillator 2 verbunden ist, wie dies beispielsweise in Fig. 10 dargestellt ist. Die Bewegungsrichtung des anzutreibenden Elementes 8 wird mittels des Umschalters 39, der dafür die Schalter 60, 61 mit den Steuereingängen 64, 65 enthält, umgeschaltet.

Die vorliegende Erfindung kann auch eine Impulsteuerung des hochpräzisen Ultraschallmotors aufweisen. Eine solche Steuerung erfolgt mit Hilfe des Ausschalters 53, der dafür den Steuereingang 54 aufweist. Der Ausschalter 53 verbindet und trennt den Rückkopplungskreis vom Leistungsverstärker 51. Dadurch gelangen Hochfrequenzimpulse der Erregerspannung auf den Oszillator 2, d.h. das anzutreibende Element 8 wird im Schrittbetrieb weiterbewegt. Die maximale Schrittgröße wird durch die Dauer des auf den Eingang 54 gegebenen Impulses bestimmt. Die minimale Schrittgröße wird durch die Auflösungsfähigkeit des Motors bestimmt, die einige Nanometer beträgt. Für die analoge Geschwindigkeitsteuerung des anzutreibenden Elements 8 besteht die Erregervorrichtung 40 des Oszillators aus einem PWM-Controller der Spannungsversorgung 76 (siehe Fig. 12). Der PWM-Controller 76 besteht aus dem PWM-Modulator 77, dem Leistungsverstärker 78 und dem Filter 79. Der PWM-Controller 76 kann einen analogen Steuereingang 80 oder eine Gruppe digitaler Steuereingänge 81 aufweisen. Durch das Anlegen des analogen Steuersignals an den Eingang 80 ändert sich die Dauer der Ausgangsimpulse des Modulators. Dies führt zur Änderung der Ausgangsspannung E, der Versorgungsspannung der Erregervorrichtung 40. Die Änderung der Versorgungsspannung E führt zur Änderung der Bewegungsgeschwindigkeit des anzutreibenden Elements 8.

Die digitalen Eingänge 81 werden zur analogen Steuerung der Geschwindigkeit des anzutreibenden Elements 8 durch das digitale Steuersignal genutzt.

Durch den PWM-Controller 76 ist es möglich, den erfindungsgemäßen Motor in präzisen Positionierungssystemen mit prozessorgesteuerten Regler und Lagegeber (prozessorgesteuerter Regler und Lagegeber in den Fig. nicht dargestellt) zu verwenden.

Das Fehlen der mechanischen Hysterese und die hohe Steifigkeit des erfindungsgemäßen Ultraschallmotors ermöglichen es, hohe Positionierungsgenauigkeiten zu erreichen, die durch die Auflösungsfähigkeit des Motors bestimmt wird, das heißt einige Nanometer für Linearmotoren und Hundertstel von Winkelsekunden für Drehmotoren.

Fig. 13 zeigt ein Anwendungsbeispiel des vorgeschlagenen hochpräzisen Ultraschallmotors in einem linearen hochpräzisen Zweikoordinatentisch. Der auf der Grundplatte 82 angeordnete Motor 83 versetzt die Zwischenplattform 84, auf der Motor 85 befestigt ist, in Bewegung. Dieser Motor versetzt die technologische Plattform 86 in Bewegung.

Der in Fig. 14 gezeigte hochpräzise Tisch besitzt eine drehbare Plattform 87, die den Motor 85 in Drehung bringt.

Der erfindungsgemäße Motor bringt, wie in Fig. 15 gezeigt, die Gruppe optischer Linsen 88 in Bewegung. Ein solcher Antrieb kann in hochpräzisen Fokussierungsmodulen eingesetzt werden. Die Verwendung einiger Module ermöglicht hochpräzise, elektronisch gesteuerte optische Objektive aufzubauen (in den Fig. nicht dargestellt).

Der in Fig. 16 dargestellte hochpräzise Theodolit besteht aus zwei Paaren der erfindungsgemäßen Motoren 83 und 85. Die Anwendung solcher Motoren gemeinsam mit dem prozessorgesteuerten Controller und dem hochauflösenden Lagegeber ermöglicht eine Positionierungsgenauigkeit des Objektivs 88 in den zwei zueinander senkrechten Achsen von +/-0,05 Winkelsekunden. Diese Genauigkeit bleibt in einem Temperaturbereich von +50 bis -20°C erhalten.

Die hier aufgezeigte technische Lehre ermöglicht es, die Positionierungsgenauigkeit der Ultraschallmotoren zu erhöhen und die Technologie zu vereinfachen, um die hochpräzisen Ultraschallmotoren in der Massenfertigung kostengünstig herzustellen. Außerdem werden die Energieverluste im Ultraschallmotor verringert, seine Erwärmung gesenkt und die entstehenden Geräusche während des Betriebs verringert. Darüber hinaus wird die Betriebsstabilität des Ultraschallmotors erhöht und der Temperatureinsatzbereich erweitert.

## Patentansprüche

1. Hochpräziser Ulträschallmotor aufweisend ein Gehäuse (1) und zumindest einen in dem Gehäuse (1) angeordneten Oszillator (2), vorzugsweise in Form einer piezoelektrischen Platte, an dem wenigstens ein Friktionselement (3) angeordnet ist, welches zur Kontaktierung einer Friktionsoberfläche (7) eines damit anzutreibenden Elements (8) vorgesehen ist, sowie einer Anpressvorrichtung (10) zum Anpressen des Friktionselements (3) an die Friktionsoberfläche (7), wobei das Gehäuse (1) zumindest zwei Stützmittel (11) zum Kontaktieren einer jeweils zugeordneten Stirnfläche (12) des Oszillators (2) aufweist
**dadurch gekennzeichnet, dass**
die Stützmittel (11) relativ zueinander verschiebbar angeordnet sind, so dass sie während der Montage des Ultraschallmotors unabhängig voneinander von einer von der jeweils zugeordneten Stirnfläche (12) beabstandeten Position in eine Anlageposition, bei welcher sie sich zumindest abschnittsweise in Anlage mit der jeweils zugeordneten Stirnfläche (12) befinden, überführbar sind.

2. Hochpräziser Ultraschallmotor nach Anspruch 1,
**dadurch gekennzeichnet, dass**
zumindest eines der Stützmittel (11) einstückig mit dem Gehäuse (1) ausgeführt ist.

3. Hochpräziser Ultraschallmotor nach Anspruch 1,
**dadurch gekennzeichnet, dass**
zumindest eines der Stützmittel (11) vor der Montage des Ultraschallmotors als vom Gehäuse (1) separates Teil vorliegt und während der Montage des Ultraschallmotors mit dem Gehäuse (1) verbindbar ist.

4. Hochpräziser Ultraschallmotor nach zumindest einem der vorangegangenen Ansprüche,
**dadurch gekennzeichnet, dass**
zumindest eines der Stützmittel (11) einen höheren Temperaturausdehnungskoeffizienten als das Gehäuse (1) aufweist.

5. Hochpräziser Ultraschallmotor nach zumindest einem der vorangegangenen Ansprüche,
**dadurch gekennzeichnet, dass**
das Gehäuse (1) einen metallischen Werkstoff, vorzugsweise Aluminium, aufweist.

6. Hochpräziser Ultraschallmotor nach zumindest einem der vorangegangenen Ansprüche,
**dadurch gekennzeichnet, dass**
zumindest eines der Stützmittel (11) einen polymeren Werkstoff, vorzugsweise einen thermoplastischen Kunststoff, aufweist.

7. Hochpräziser Ultraschallmotor nach zumindest einem der vorangegangenen Ansprüche,
**dadurch gekennzeichnet, dass**
das Gehäuse (1) wenigstens zwei Gehäuseteile (4, 5) aufweist.

8. Hochpräziser Ultraschallmotor nach zumindest einem der vorangegangenen Ansprüche,
**dadurch gekennzeichnet, dass**
die Gehäuseteile (4, 5) im Wesentlichen gleiche Geometrie und/oder gleiche Abmessungen und/oder gleiche Ausführung aufweisen.

9. Hochpräziser Ultraschallmotor nach zumindest einem der vorangegangenen Ansprüche,
**dadurch gekennzeichnet, dass**
zumindest eines der Stützmittel (11) wenigstens einen akustisch beweglichen Abschnitt (29), vorzugsweise in Form einer Membran oder eines flachen Bandes, aufweist.

10. Hochpräziser Ultraschallmotor nach zumindest einem der vorangegangenen Ansprüche,
**dadurch gekennzeichnet, dass**
der akustisch bewegliche Abschnitt (29) als einseitig freier Schenkel ausgeführt ist.

11. Hochpräziser Ultraschallmotor nach zumindest einem der vorangegangenen Ansprüche,
**dadurch gekennzeichnet, dass**
eine zur Kontaktierung der zugeordneten Stirnfläche (12) des Oszillators (2) vorgesehene Oberfläche zumindest eines Stützmittels (11) eine im Wesentlichen ebene Fläche aufweist.

12. Hochpräziser Ultraschallmotor nach zumindest einem der vorangegangenen Ansprüche,
**dadurch gekennzeichnet, dass**
zumindest eines der Stützmittel (11) einen Vorsprungsabschnitt (33) aufweist.

13. Hochpräziser Ultraschallmotor nach zumindest einem der vorangegangenen Ansprüche,
**dadurch gekennzeichnet, dass**
die Anpressvorrichtung (10) Rund- oder Flachfedern aufweist.

14. Hochpräziser Ultraschallmotor nach zumindest einem der vorangegangenen Ansprüche,
**dadurch gekennzeichnet, dass**
zumindest eines der Stützmittel (11) in Anlageposition durch eine Fixierungsvorrichtung (6) fixierbar ist.

15. Hochpräziser Ultraschallmotor nach zumindest einem der vorangegangenen Ansprüche,
**dadurch gekennzeichnet, dass**
die Fixierungsvorrichtung (6) zumindest eine Schraube und/oder einen Fixierbolzen und/oder eine Sperrklinke aufweist.

## Claims

1. High-precision ultrasonic motor, comprising a housing (1) and at least one oscillator (2) arranged in the housing (1), preferably in the form of a piezoelectric plate, on which at least one friction element (3) is arranged, which is provided to contact a friction surface (7) of an element (8) to be driven thereby, and a press-on device (10) for pressing the friction element (3) against the friction surface (7), wherein the housing (1) has at least two support means (11) for contacting a respectively associated end face (12) of the oscillator (2)
**characterized in that**
the support means (11) are arranged to be displaceable relative to each other, such that, during installation of the ultrasonic motor, the support means (11) can be transferred independently of each other from a position in which the support means (11) are spaced away from the respectively associated end face (12), into a contact position in which they contact the respectively associated end face (12) at least in sections.

2. High-precision ultrasonic motor according to claim 1,
**characterized in that**
at least one of the support means (11) is formed integrally with the housing (1).

3. High-precision ultrasonic motor according to claim 1,
**characterized in that**
at least one of the support means (11) is provided as a part separated from the housing (1) before the ultrasonic motor is installed and is connectable to the housing (1) during the installation of the ultrasonic motor.

4. High-precision ultrasonic motor according to at least one of the preceding claims,
**characterized in that**
at least one of the support means (11) has a higher temperature expansion coefficient than the housing (1).

5. High-precision ultrasonic motor according to at least one of the preceding claims,
**characterized in that**
the housing (1) includes a metallic material, preferably aluminium.

6. High-precision ultrasonic motor according to at least one of the preceding claims,
**characterized in that**
at least one of the support means (11) includes a polymer material, preferably a thermoplastic material.

7. High-precision ultrasonic motor according to at least one of the preceding claims,
**characterized in that**
the housing (1) comprises at least two housing parts (4, 5).

8. High-precision ultrasonic motor according to at least one of the preceding claims,
**characterized in that**
the housing parts (4, 5) substantially have the same geometry and/or same dimensions and/or same configuration.

9. High-precision ultrasonic motor according to at least one of the preceding claims,
**characterized in that**
at least one of the support means (11) comprises at least one acoustically movable section (29), preferably in form of a membrane or a flat band.

10. High-precision ultrasonic motor according to at least one of the preceding claims,
**characterized in that**
the acoustically movable section (29) is formed as a leg which is free on one side.

11. High-precision ultrasonic motor according to at least one of the preceding claims,
**characterized in that**
a surface of at least one support means (11), which is provided to contact the associated end face (12) of the oscillator (2), has a substantially flat surface.

12. High-precision ultrasonic motor according to at least one of the preceding claims,
**characterized in that**
at least one of the support means (11) comprises a protruding section (33).

13. High-precision ultrasonic motor according to at least one of the preceding claims,
**characterized in that**
the press-on device (10) comprises round or flat springs.

14. High-precision ultrasonic motor according to at least one of the preceding claims,
**characterized in that**
at least one of the support means (11) can be fixed in the contact position by a fixing device (6).

15. High-precision ultrasonic motor according to at least one of the preceding claims,
**characterized in that**
the fixing device (6) comprises at least a screw and/or a fixing bolt and/or a detent pawl.

## Revendications

1. Moteur à ultrasons de haute précision, comprenant un boîtier (1) et au moins un oscillateur (2) agencé dans le boîtier (1), de préférence sous la forme d'une plaque piézo-électrique, sur lequel est agencé au moins un élément à friction (3) qui est prévu pour venir en contact avec une surface de friction (7) d'un élément (8) à entraîner avec celui-ci, ainsi qu'un dispositif de pressage (10) pour presser l'élément de friction (3) contre la surface de friction (7), dans lequel le boîtier (1) comprend au moins deux organes de soutien (11) pour venir en contact avec une surface frontale respective associée (12) de l'oscillateur (2),
**caractérisé en ce que**
les organes de soutien (11) sont agencés avec possibilité de translation l'un par rapport à l'autre de sorte que, pendant le montage du moteur à ultrasons, ils peuvent être transférés indépendamment l'un de l'autre depuis une position écartée de la surface frontale (12) respective associée jusque dans une position de contact dans laquelle ils se trouvent au moins par tronçons en contact avec la surface frontale (12) respective associée.

2. Moteur à ultrasons de haute précision selon la revendication 1,
**caractérisé en ce que** l'un au moins des organes de soutien (11) est réalisé d'une seule pièce avec le boîtier (1).

3. Moteur à ultrasons de haute précision selon la revendication 1,
**caractérisé en ce que** l'un au moins des organes de soutien (11) se présente, avant le montage du moteur à ultrasons, sous la forme d'une pièce séparée du boîtier (1) et peut, pendant le montage du moteur à ultrasons, être relié avec le boîtier (1).

4. Moteur à ultrasons de haute précision selon l'une au moins des revendications précédentes,
**caractérisé en ce que** l'un au moins des organes de soutien (11) présente un coefficient de dilatation en température plus élevé que le boîtier (1).

5. Moteur à ultrasons de haute précision selon l'une au moins des revendications précédentes,
**caractérisé en ce que** le boîtier (1) comporte un matériau métallique, de préférence de l'aluminium.

6. Moteur à ultrasons de haute précision selon l'une au moins des revendications précédentes,
**caractérisé en ce que** l'un au moins des organes de soutien (11) comporte un matériau polymère, de préférence une matière thermoplastique.

7. Moteur à ultrasons de haute précision selon l'une au moins des revendications précédentes,
**caractérisé en ce que** le boîtier (1) comprend au moins deux parties de boîtier (4, 5).

8. Moteur à ultrasons de haute précision selon l'une au moins des revendications précédentes,
**caractérisé en ce que** les parties de boîtier (4, 5) présentent sensiblement la même géométrie et/ou les mêmes dimensions et/ou la même réalisation.

9. Moteur à ultrasons de haute précision selon l'une au moins des revendications précédentes,
**caractérisé en ce que** l'un au moins des organes de soutien (11) comprend au moins un tronçon acoustiquement déplaçable (29), de préférence sous la forme d'une membrane ou d'une bande plane.

10. Moteur à ultrasons de haute précision selon l'une au moins des revendications précédentes,
**caractérisé en ce que** le tronçon acoustiquement déplaçable (29) est réalisé sous la forme d'une branche libre sur un côté.

11. Moteur à ultrasons de haute précision selon l'une au moins des revendications précédentes,
**caractérisé en ce qu'**une surface d'au moins un organe de soutien (11), prévue pour venir en contact avec la surface frontale associée (12) de l'oscillateur (2), présente une surface sensiblement plane.

12. Moteur à ultrasons de haute précision selon l'une au moins des revendications précédentes,
**caractérisé en ce que** l'un au moins des organes de soutien (11) comporte un tronçon en saillie (33).

13. Moteur à ultrasons de haute précision selon l'une au moins des revendications précédentes,
**caractérisé en ce que** le dispositif de pressage (10) comprend des ressorts arrondis ou des ressorts plats.

14. Moteur à ultrasons de haute précision selon l'une au moins des revendications précédentes,
**caractérisé en ce que** l'un au moins des organes de soutien (11) est susceptible d'être fixé dans la position de contact par un dispositif de fixation (6).

15. Moteur à ultrasons de haute précision selon l'une au moins des revendications précédentes,
**caractérisé en ce que** le dispositif de fixation (6) comprend au moins une vis et/ou un boulon de fixation et/ou un loquet de blocage.
